# EUROPEAN PATENT APPLICATION

(11) **EP 4 350 745 A1**
(43) Date of publication of application: **10.04.2024**
(21) Application number: 22811419.5
(22) Date of filing: 27.05.2022
(51) Int. Cl.: H01L 21/316

(54) **METAL COMPOUND FILM PRODUCTION METHOD**

(30) Priority: 28.05.2021 JP 2021089729; 26.05.2022 JP 2022086014
(71) Applicant: Mitsubishi Materials Corporation, Tokyo 100-8117 (JP)
(72) Inventor: TSUJIUCHI, Naoto, Sanda-shi, Hyogo 669-1339 (JP); SOYAMA, Nobuyuki, Naka-shi, Ibaraki 311-0102 (JP)
(74) Representative: Hoffmann Eitle
(86) International application number: PCT/JP2022/021802
(87) International publication number: WO 2022/250151

(57) **Abstract**

A method of manufacturing a metal compound film of the present invention is a method of manufacturing a metal compound film in which a compound generating liquid containing, as a solute component, a substance that generates a metal compound is applied to a substrate (11) having an opening portion (12) on a surface and sintered to form a metal compound film(15), including: a pre-wet liquid application step S01 of applying a pre-wet liquid (21) to the surface of the substrate (11), and filling the opening portion (12) with the pre-wet liquid (21), the pre-wet liquid having better wettability to the substrate than the compound generating liquid; a compound generating liquid application step S02 of applying the compound generating liquid to stack the compound generating liquid on the pre-wet liquid (21) on the substrate (11), and diffusing the solute component of the compound generating liquid in the pre-wet liquid (21); and a sintering step S04 of sintering the applied compound generating liquid to form the metal compound film (15).

## Description

### TECHNICAL FIELD

The present invention relates to a method of manufacturing a metal compound film that is used as a hard mask during etching.

Priority is claimed on Japanese Patent Application No. 2021-089729, filed May 28, 2021, and Japanese Patent Application No. 2022-086014, filed May 26, 2022, the contents of which are incorporated herein by reference.

### BACKGROUND ART

In the related art, for example, in a semiconductor process, a polymer of an organic resist agent has been widely used as an etching mask in carrying out an etching treatment for forming a pattern on a surface of a substrate such as silicon.

However, there is a concern that the polymer may be easily etched by a reactant gas such as oxygen, fluorine, and chlorine. In addition, the organic resist agent has a problem that it is easily deteriorated when subjected to plasma etching.

Therefore, as an etching mask particularly during plasma etching, for example, a hard mask using a metal compound film made of a metal compound such as a metal oxide, a metal nitride, or a metal oxynitride is provided as described in Patent Documents 1 to 3. The metal compound film is particularly suitable as a hard mask since it is resistant to plasma etching and can be relatively easily peeled off with a strongly acidic solution.

Examples of the method of depositing the above-described metal compound film on a substrate surface include a sol-gel method using a sol-gel solution. By applying a sol-gel solution of a metal compound to a substrate surface and sintering the sol-gel solution, a metal compound film can be deposited through a relatively simple manufacturing process.

Here, an opening portion may be previously formed in various forms, such as trench (groove) and a hole, on the surface of the substrate.

In a case where a metal compound film is used as a hard mask, it is necessary to deposit the metal compound film so that the above-described opening portion is also filled with the metal compound.

Recently, in the semiconductor fields, small-sizing and high integration have proceeded, and an opening area of an opening portion such as a trench (groove) and a hole formed on a surface of a substrate tends to become narrower.

In a case where a sol-gel solution is applied on a substrate on which an opening portion having a narrow opening area is formed, the opening portion is not sufficiently filled with the sol-gel solution due to the surface tension of the sol-gel solution, and there is a concern that many voids may be present on a metal compound film to be formed after sintering.

Examples of the method of depositing a metal compound film by filling an opening portion with a metal compound include atomic layer deposition (ALD), which is a type of CVD method.

In addition, Patent Document 1 proposes a method in which the interfacial energy of side surfaces and a bottom surface of an opening portion is reduced to promote the filling of the opening portion with a filling material (sol-gel solution) having a liquid form, and a metal compound film is formed.

### [Citation List]

### [Patent Documents]

[Patent Document 1]
   Published Japanese Translation No. 2019-510366 of the PCT International Publication
[Patent Document 2]
   Japanese Unexamined Patent Application, First Publication No. H10-194873
[Patent Document 3]
   Japanese Unexamined Patent Application, First Publication No. 2014-077082

### SUMMARY OF INVENTION

### Technical Problem

However, in the above-described atomic layer deposition method, the manufacturing cost was extremely high, and it was difficult to industrially and widely use the method.

In addition, in Patent Document 1, since a process for reducing the interfacial energy of the side surfaces and the bottom surface of the opening portion is required, problems arise in that the manufacturing process becomes very complicated and the metal compound film cannot be efficiently deposited.

The present invention has been made in view of the above-described circumstances, and an objective thereof is to provide a method of manufacturing a metal compound film in which in the deposition of a metal compound film on a substrate having an opening portion on a surface, the opening portion can be filled with a metal compound, and a metal compound film having few voids can thus be efficiently deposited.

### Solution to Problem

In order to solve the problems, a method of manufacturing a metal compound film according to Aspect 1 of the present invention is a method of manufacturing a metal compound film in which a compound generating liquid containing, as a solute component, a substance that generates a metal compound is applied to a substrate having an opening portion on a surface and sintered to form a metal compound film, including: a pre-wet liquid application step of applying a pre-wet liquid to the surface of the substrate, and filling the opening portion with the pre-wet liquid, the pre-wet liquid having better wettability to the substrate than the compound generating liquid; a compound generating liquid application step of applying the compound generating liquid to stack the compound generating liquid on the pre-wet liquid on the substrate, and diffusing the solute component of the compound generating liquid in the pre-wet liquid; and a sintering step of sintering the applied compound generating liquid to form the metal compound film.

In the method of manufacturing a metal compound film according to Aspect 1 of the present invention, since the pre-wet liquid having better wettability to the substrate than the compound generating liquid containing, as a solute component, a substance that generates a metal compound is applied to the surface of the substrate, it is possible to sufficiently fill the opening portion on the surface of the substrate with the pre-wet liquid.

Further, since the compound generating liquid is applied in a state in which the opening portion on the substrate surface is filled with the pre-wet liquid, the solute component of the compound generating liquid is diffused in the pre-wet liquid, and the opening portion on the substrate surface is filled with the solute component of the compound generating liquid.

In this state, by performing the sintering step, it is possible to deposit a metal compound film having few voids, in which the opening portion on the substrate surface is filled with the metal compound. In addition, it is possible to efficiently deposit a metal compound film having few voids through a relatively simple manufacturing process.

According to Aspect 2 of the present invention, in the method of manufacturing a metal compound film according to Aspect 1, the compound generating liquid is a sol-gel solution, and a drying step of drying the applied sol-gel solution to form a metal compound gel film, and a sintering step of sintering the metal compound gel film to form the metal compound film are provided.

In the method of manufacturing a metal compound film according to Aspect 2 of the present invention, the compound generating liquid is a sol-gel solution, a drying step of drying the applied sol-gel solution to form a metal compound gel film, and a sintering step of sintering the metal compound gel film to form the metal compound film are provided, and using the sol-gel solution, it is possible to deposit a metal compound film having few voids, in which the opening portion on the substrate surface is filled with the metal compound.

According to Aspect 3 of the present invention, in the method of manufacturing a metal compound film according to Aspect 1 or 2, in the pre-wet liquid application step, the pre-wet liquid is applied by a spin coating method.

In the method of manufacturing a metal compound film according to Aspect 3 of the present invention, since the pre-wet liquid is applied by a spin coating method, it is possible to sufficiently fill the opening portion on the substrate surface with the pre-wet liquid.

According to Aspect 4 of the present invention, in the method of manufacturing a metal compound film according to any one of Aspects 1 to 3, in the pre-wet liquid application step, the pre-wet liquid is a supercritical fluid.

In the method of manufacturing a metal compound film according to Aspect 4 of the present invention, since the pre-wet liquid is a supercritical fluid, the wettability to the substrate is improved and it is possible to sufficiently fill the opening portion on the substrate surface with the pre-wet liquid.

### ADVANTAGEOUS EFFECTS OF INVENTION

According to the present invention, it is possible to provide a method of manufacturing a metal compound film in which in the deposition of a metal compound film on a substrate having an opening portion on a surface, the opening portion can be filled with a metal compound, and a metal compound film having few voids can thus be efficiently deposited.

### BRIEF DESCRIPTION OF DRAWINGS

FIG. 1 is a flowchart showing a method of manufacturing a metal compound film according to one embodiment of the present invention.
FIG. 2 is an explanatory view showing the method of manufacturing a metal compound film according to one embodiment of the present invention.

### DESCRIPTION OF EMBODIMENTS

Hereinafter, a method of manufacturing a metal compound film according to an embodiment of the present invention will be described.

In the method of manufacturing a metal compound film according to the present embodiment, for example, a metal compound film that is deposited on a surface of a substrate such as a semiconductor wafer and used as a hard mask during an etching treatment is targeted.

In the present embodiment, depositing a metal oxide film that is a type of metal compound film will be described. In addition, in the present embodiment, using a sol-gel solution containing a metal oxide as a compound generating liquid (compound forming liquid) will be described.

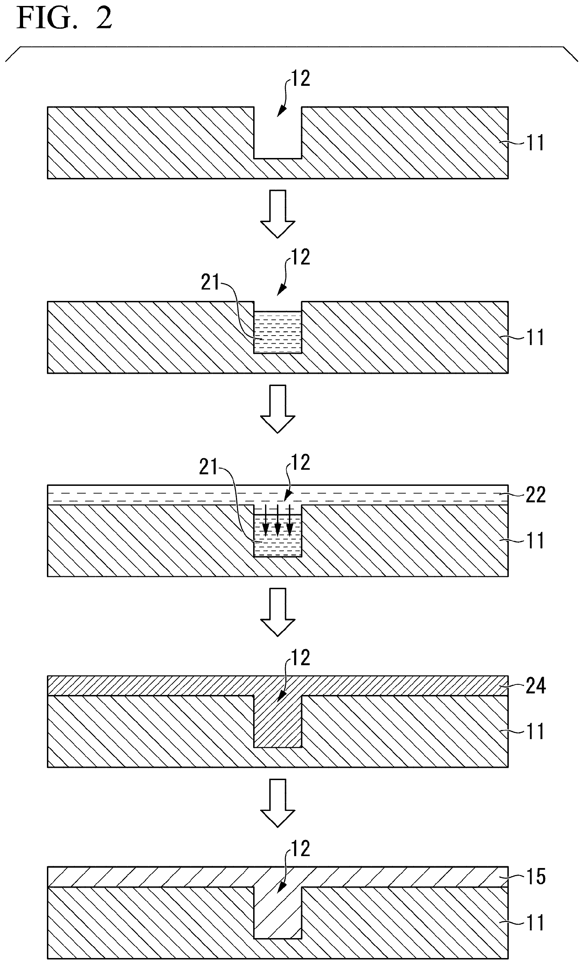

In the method of manufacturing a metal compound film according to the present embodiment, as shown in FIG. 2, a metal oxide film 15 is deposited on a substrate 11 whose surface has an opening portion 12 such as a trench of a hole formed thereon.

Here, in the present embodiment, the opening portion 12 is formed of a trench (groove) having an opening width of 10 nm or greater and 3 µm or less and a depth of 5 nm or greater and 500 nm or less.

Examples of the substrate 11 include a silicon substrate, a sapphire substrate, and a GaN substrate. In the present embodiment, a silicon substrate is used.

In addition, the metal oxide constituting the metal oxide film 15 is not particularly limited, and various metal oxides can be applied. However, in the present embodiment, any one or more of aluminum oxide, hafnium oxide, zirconium oxide, tungsten oxide, and titanium oxide are contained.

The metal oxide film 15 is deposited by sintering a sol-gel solution 22 containing a metal oxide.

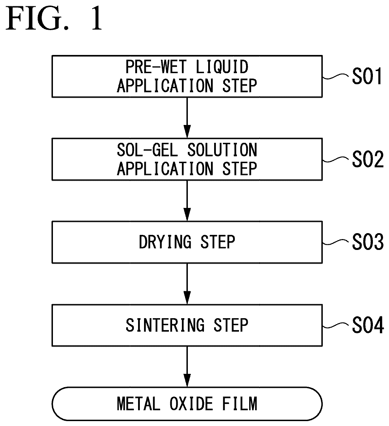

In addition, the method of manufacturing a metal compound film according to the present embodiment includes, as shown in FIGS. 1 and 2: a pre-wet liquid application step S01 in which a pre-wet liquid 21 having better wettability to the substrate 11 than the sol-gel solution 22 is applied to a surface of the substrate 11 and the opening portion 12 is filled with the pre-wet liquid 21; a sol-gel solution application step S02 in which the sol-gel solution 22 is applied to be stacked on the pre-wet liquid 21 on the substrate 11 and the solute component of the sol-gel solution 22 is diffused in the pre-wet liquid 21; a drying step S03 in which the applied sol-gel solution 22 is dried to form a metal oxide gel film 24; and a sintering step S04 in which the metal oxide gel film 24 is sintered and the metal oxide film 15 is formed. The contact angle of the pre-wet liquid 21 with respect to the substrate 11 is smaller than the contact angle of the sol-gel solution 22 with respect to the substrate 11. The contact angle of the pre-wet liquid 21 with respect to the substrate 11 is preferably 50° or less, and the contact angle of the sol-gel solution 22 with respect to the substrate 11 is preferably 80° or less. These contact angles are preferably small, that is, close to 0°. The contact angle of the pre-wet liquid 21 with respect to the substrate 11 can be adjusted to 1° or greater, and the contact angle of the sol-gel solution 22 with respect to the substrate 11 can be adjusted to 0° or greater.

In the pre-wet liquid application step 501, as described above, the pre-wet liquid 21 having better wettability to the substrate 11 than the sol-gel solution 22 is applied, and thus the opening portion 12 formed on the surface of the substrate 11 is filled with the pre-wet liquid 21. As shown in FIG. 2, the entire opening portion 12 may not be filled with the pre-wet liquid 21, and at least a bottom region of the opening portion 12 may be sufficiently wetted with the pre-wet liquid 21.

Purer water, an alcohol having 4 or less carbon atoms such as ethanol, an alcohol having an ether bond such as propylene glycol monomethyl ether (PGME), or the like is preferably used as the pre-wet liquid 21.

In addition, in the pre-wet liquid application step S01, the pre-wet liquid 21 is preferably applied by a spin coating method. It is possible to sufficiently fill the opening portion 12 with the pre-wet liquid 21 by applying the spin coating method.

Furthermore, the pre-wet liquid 21 is preferably applied as a supercritical fluid at a temperature above a critical temperature and a pressure above a critical pressure. Since the supercritical fluid has particularly excellent wettability, it is possible to sufficiently fill the opening portion 12 with the pre-wet liquid 21.

In the sol-gel solution application step S02, as described above, the sol-gel solution 22 is applied to be stacked on the pre-wet liquid 21 on the substrate 11 and the solute component of the sol-gel solution 22 is diffused in the pre-wet liquid 21. The sol-gel solution 22 can also be applied by the spin coating method. Accordingly, the opening portion 12 is also sufficiently filled with the solute component of the sol-gel solution 22. For example, the solute component of the sol-gel solution 22 is diffused in the pre-wet liquid 21 by being left for 5 seconds to 10 seconds.

In the present embodiment, the sol-gel solution 22 contains, as the solute component, one or more selected from aluminum alkoxide, hafnium alkoxide, zirconium alkoxide, tungsten alkoxide, and silicon alkoxide, for example. In addition, examples of the solvent of the sol-gel solution 22 include ethanol, 1-butanol, and PGME.

In the drying step S03, the substrate 11 to which the pre-wet liquid 21 and the sol-gel solution 22 have been applied is heated and dried to form the metal oxide gel film 24. As described above, since the opening portion 12 is filled with the solute component of the sol-gel solution 22, the opening portion 12 becomes filled with the metal oxide gel.

It is preferable that the heating in the drying step S03 be performed under conditions of an air atmosphere, a heating temperature of 50°C or higher and 300°C or lower, and a retention time of 1 minute or longer and 10 minutes or shorter at the heating temperature.

Here, by repeatedly performing the sol-gel solution application step S02 and the drying step S03, the metal oxide gel film 24 having a predetermined thickness is formed.

In a case where the opening portion 12 is not filled after the drying step S03, the pre-wet liquid application step S01, the sol-gel solution application step S02, and the drying step S03 may be repeatedly performed. In a case when the steps are repeated, it is not necessary to perform the pre-wet liquid application step S01 for the second time and thereafter.

In the sintering step S04, the metal oxide gel film 24 is sintered by being heated, and thus the metal oxide film 15 is formed. As described above, since the opening portion 12 is filled with the metal oxide gel, the opening portion 12 becomes filled with the metal oxide.

It is preferable that the heating in the sintering step S04 be performed under conditions of an air atmosphere or an oxygen atmosphere, a heating temperature of 400°C or higher and 800°C or lower, and a retention time of 3 minutes or longer and 10 minutes or shorter at the heating temperature.

In a case where the sol-gel solution application step S02 and the drying step S03 are repeated, the sintering step S04 may be performed after each drying step S03.

Through the above steps, the metal oxide film 15 according to the present embodiment is manufactured.

In the method of manufacturing a metal compound film according to the present embodiment configured as described above, since the pre-wet liquid 21 having better wettability to the substrate 11 than the sol-gel solution 22 is applied to the surface of the substrate 11 in the pre-wet liquid application step S01, it is possible to sufficiently fill the opening portion 12 on the surface of the substrate 11 with the pre-wet liquid 21.

In addition, in the sol-gel solution application step S02, since the sol-gel solution 22 is applied in a state in which the opening portion 12 of the substrate 11 is filled with the pre-wet liquid 21, the solute component of the sol-gel solution 22 is diffused in the pre-wet liquid 21, and the opening portion 12 of the substrate 11 is filled with the solute component of the sol-gel.

In this state, by performing the drying step S03 and the sintering step S04, it is possible to deposit the metal oxide film 15 having few voids, in which the opening portion 12 of the substrate 11 is filled with the metal oxide.

In the present embodiment, with a configuration in which the pre-wet liquid 21 is applied by a spin coating method in the pre-wet liquid application step S01, it is possible to sufficiently fill the opening portion 12 of the substrate 11 with the pre-wet liquid 21. Accordingly, the opening portion 12 of the substrate 11 can be reliably filled with the metal oxide, and the metal oxide film 15 having few voids can be deposited.

In the present embodiment, in a case where the pre-wet liquid 21 is applied as a supercritical fluid at a temperature above a critical temperature and a pressure above a critical pressure in the pre-wet liquid application step S01, the wettability between the pre-wet liquid 21 and the substrate 11 is further improved and it is possible to sufficiently fill the opening portion 12 of the substrate 11 with the pre-wet liquid 21. Accordingly, the opening portion 12 of the substrate 11 can be reliably filled with the metal oxide, and the metal oxide film 15 having few voids can be deposited.

The embodiments of the present invention have been described as above, but the present invention is not limited thereto, and can be appropriately changed without departing from the technical ideas of the present invention.

In the present embodiment, the deposition of the metal oxide film that is a type of metal compound film using the sol-gel solution containing a metal oxide as a compound forming liquid has been described. However, the present invention is not limited thereto, and the metal compound film may be a metal nitride film or a metal oxynitride film. For example, in the deposition of a silicon nitride film that is a type of metal nitride film or a silicon oxynitride film that is a type of metal oxynitride film, a compound forming liquid containing polysilazane or the like as a solute component is used.

### [Industrial Applicability]

According to the present invention, it is possible to provide a method of manufacturing a metal compound film in which in the deposition of a metal compound film on a substrate having an opening portion on a surface, the opening portion can be filled with a metal compound, and a metal compound film having few voids can thus be efficiently deposited.

### REFERENCE SIGNS LIST

11: Substrate
12: Opening portion
15: Metal oxide film (metal compound film)
21: Pre-wet liquid
22: Sol-gel solution (compound forming liquid)
24: Metal oxide gel film
S01: Pre-wet liquid application step
S02: Sol-gel solution application step (compound generating liquid application step)
S03: Drying step
S04: Sintering step

## Claims

1. A method of manufacturing a metal compound film in which a compound generating liquid containing, as a solute component, a substance that generates a metal compound is applied to a substrate having an opening portion on a surface and sintered to form a metal compound film, the method comprising:
a pre-wet liquid application step of applying a pre-wet liquid to the surface of the substrate, and filling the opening portion with the pre-wet liquid, the pre-wet liquid having better wettability to the substrate than the compound generating liquid;
a compound generating liquid application step of applying the compound generating liquid to stack the compound generating liquid on the pre-wet liquid on the substrate, and diffusing the solute component of the compound generating liquid in the pre-wet liquid; and
a sintering step of sintering the applied compound generating liquid to form the metal compound film.

2. The method of manufacturing a metal compound film according to Claim 1,
wherein the compound generating liquid is a sol-gel solution, and
a drying step of drying the applied compound generating liquid to form a metal compound gel film, and
a sintering step of sintering the metal compound gel film to form the metal compound film are provided.

3. The method of manufacturing a metal compound film according to Claim 1 or 2,
wherein in the pre-wet liquid application step, the pre-wet liquid is applied by a spin coating method.

4. The method of manufacturing a metal compound film according to Claim 1 or 2,
wherein in the pre-wet liquid application step, the pre-wet liquid is a supercritical fluid.
